# EUROPEAN PATENT APPLICATION

(11) **EP 4 502 635 A1**
(43) Date of publication of application: **05.02.2025**
(21) Application number: 24020077.4
(22) Date of filing: 11.03.2024
(51) Int. Cl.: G01R 33/10, G01R 33/12, G01R 33/07, G01R 33/00

(54) **MAGNETIC FIELD SENSOR ARRAY AND METHOD FOR MEASURING A MAGNETIC FIELD, ETC**

(30) Priority: 31.07.2023 CH 8292023; 05.08.2023 CH 8452023; 20.12.2023 EP 23020566
(71) Applicant: Senis AG, 6300 Zug (CH)
(72) Inventor: Stuck, Alexander, 5430 Wettingen (CH); Urban, Maciej Józef, 6438 Ibach (CH); Popovic, Radivoje, 6340 Zug (CH)
(74) Representative: Körner, Thomas Ottmar

(57) **Abstract**

A magnetic field sensor array, in particular for measuring a magnetic field distribution, comprises:
a) a semiconductor substrate;
b) a plurality of magnetic field sensors, in particular Hall sensors, provided on and/or within a surface layer of the semiconductor substrate; characterized by
c) an at least partially transparent protection layer, in particular a glass layer or plastic layer, covering the plurality of magnetic field sensors.

## Description

The invention pertains to the field of magnetic field cameras. It relates to a magnetic field sensor array, in particular a Hall sensor array, to be used as or in a magnetic field camera and to a method for determining a magnetic field created by an object in accordance with the independent patent claims.

### TECHNICAL BACKGROUND

In measuring and producing magnetic systems, it is often necessary to correlate magnetic field distributions around a system with the geometry of parts comprised by the system. For example, in a production, in particular an industrial production, of magnets, quantities like a magnetic field direction and strength and/or magnitude might be measured, in particular at a plurality of locations to obtain a spatial distribution of said quantities, and may be correlated with a position, orientation, shape and/or geometry of the magnets. If the field created by a particular magnet points too much in a wrong direction, is to weak or to strong, and/or has a spatial distribution that deviates too much from an expected and/or specified distribution, then this particular magnet might be treated as a reject.

Fast and accurate determination of a respective spatial correlation can be difficult, particularly for smaller magnets or magnetic systems, as minor misalignments between magnetic field and shape and/or geometry measurement systems can significantly affect the spatial correlation. It would be desirable to have simple and robust means of making such a correlation, especially under rough conditions, such as vibrations, on the factory floor.

For about ten years now, magnetic field cameras (also referred to as magnetic cameras) have been used to measure smaller magnetic field distributions. They are essentially sensor arrays comprising a plurality of magnetic field sensors (like, e.g., Hall sensors), often integrated into a semiconductor, that measure the magnetic field in a plane or along a line. To protect the sensors from an environment, all known existing magnetic camera systems are provided in a package or casing which is optically not transparent. As a consequence, the individual sensors and the sensor array are not visible, and may not be seen by any kind of optical camera operating in an UV-A, visible and/or near-infrared spectral range, which significantly complicates an accurate determination of the spatial correlation.

A more recent type of magnetic field cameras is based on the principles described in international patent application publication WO 2022/136275 A1. This type of camera does generally not comprise discrete magnetic field sensors, which may also complicate an accurate determination of the spatial correlation between magnetic field distribution and geometry.

Therefore, it would be desirable to find new magnetic field sensor arrays and methods for measuring a magnetic field that overcome the disadvantages as detailed above.

### SUMMARY OF THE INVENTION

The above objective and other objectives are achieved by a magnetic field sensor array and method for measuring a magnetic field. Preferred embodiments and/or variations of the invention are presented in dependent claims.

A magnetic field sensor in accordance with the invention as hereinafter claimed may comprise the features of claim 1 below.

A method for determining a magnetic field around an object in accordance with the invention as hereinafter claimed may comprise the features of claim 10 below.

The dependent patent claims specify detail related to preferred embodiments.

One aspect of the present invention proposes to cover the magnetic field sensor array with an optically transparent layer. This layer can be fully transparent or transparent in a wide or narrow wavelength band in the visible and IR parts of the spectrum. If the sensor has some visible micro- and/or mesostructures on its surface, the position of these structures can now be measured with an optical measurement system, such as an industrial camera with a telecentric lens. By design, the position of the magnetic field-sensitive volumes in the sensor is very well known in relation to the visible micro-/mesostructures, very often with sub-micron accuracy. Supposing a magnetic object is placed close to the sensor, and an image is taken with a measurement camera. In that case, the optical measurement will directly reveal the relative position of the object's outer shape to the magnetic sensor. The accuracy of this measurement is only limited by the lateral depth resolution of the optical system. The image from the magnetic sensor and the optical image can be very accurately superimposed, which is the final goal. Furthermore, if several micro-/mesostructures are on the magnetic sensor surface, it is also straightforward to correct any optical distortion close to the sensor plane; these structures may work as an inbuilt scale in the optical image.

### BRIEF DESCRIPTION OF THE DRAWINGS

The subject matter of the invention will be explained with respect to further optional detail in the following text with reference to the above and further exemplary embodiments which are illustrated in the attached drawings.
Fig. 1 shows a top view of an exemplary magnetic field sensor array;
Fig. 2 illustrates an exemplary image of an object placed on the magnetic field sensor array; and
Fig. 3 illustrates the intensity distribution on the surface of a semiconductor substrate for an exemplary situation where an object is placed directly on the surface of a magnetic field sensor;
Fig. 4 illustrates an exemplary first intensity distribution on the surface of a semiconductor substrate 10' for an exemplary situation where an object is placed above, adjacent to and/or opposite a semiconductor substrate and/or a magnetic field sensitive optical element.

### DETAILED DESCRIPTION OF EXEMPLARY EMBODIMENTS

The present invention may, in particular, be put into practice in the form of one or more of the following numbered embodiments:
1) A magnetic field sensor array, in particular for measuring a magnetic field distribution, said magnetic field sensor array comprising:
   a) a semiconductor substrate;
   b) a plurality of magnetic field sensors, in particular Hall sensors, provided on and/or within a surface layer of the semiconductor substrate; characterized by
   c) an at least partially transparent protection layer, in particular a glass layer or plastic layer, covering the plurality of magnetic field sensors.
2) The magnetic field sensor array of embodiment 1, wherein the at least partially transparent protection layer is at least partially transparent to at least a subrange of wavelengths from a UV-A, visible and/or near-infrared spectral range.
3) The magnetic field sensor array of any preceding embodiment, wherein for at least one wavelength or range of wavelengths from a UV-A, visible and/or near-infrared spectral range, the at least partially transparent protection layer has a transmittance or a transmission coefficient of at least 0.2, preferably of at least 0.5, most preferably of at least 0.8.
4) The magnetic field sensor array of any preceding embodiment, wherein a maximum transmittance or a maximum transmission coefficient of the at least partially transparent protection layer within the UV-A, visible and/or near-infrared spectral range is 0.8, preferably 0.5, and most preferably 0.2.
5) The magnetic field sensor array of any preceding embodiment, wherein the at least partially transparent protection layer is attached, in particular permanently and/or irreversibly attached, to the semiconductor substrate, in particular to the surface layer of the semiconductor substrate, in particular by gluing, pasting or casting.
6) The magnetic field sensor array of any preceding embodiment, wherein the at least partially transparent protection layer is a cast layer, in particular formed from an epoxy resin.
7) The magnetic field sensor array of any preceding embodiment, wherein at least a subset of the magnetic field sensors comprises a unique, visible identifier, in particular a combination of digits, numbers and/or letters, wherein each identifier is preferably different from any other identifier from the subset of magnetic field sensors.
8) The magnetic field sensor array of any preceding embodiment, wherein the magnetic field sensors are arranged in an array having N lines or rows, and M columns of sensors.
9) The magnetic field sensor array of any preceding embodiment, further comprising a plurality of light sensitive elements arranged on and/or within a surface layer of the semiconductor substrate.
10) The magnetic field sensor array of any preceding embodiment, wherein a number *N*ₗ of light sensitive elements is equal to or larger than a number *N*ₘ of magnetic field sensors, in particular with *N*ₘ = *N* · *M.*
11) The magnetic field sensor array of any preceding embodiment, wherein in each line and/or each column,
   a) at least one light sensitive element is interposed between any two adjacent magnetic field sensors; and/or
   b) exactly one magnetic field sensor is interposed between any two adjacent light sensitive elements.
12) The magnetic field sensor array of any preceding embodiment, wherein the light sensitive elements and the magnetic field sensors are alternatingly arranged in a checkerboard fashion.
13) The magnetic field sensor array of any preceding embodiment, wherein at least some, in particular each, of the light sensitive elements comprise(s) a photodiode, in particular a CMOS cell, or a pixel of a charge-coupled device, CCD, image sensor.
14) The magnetic field sensor array of any preceding embodiment, wherein each of the light sensitive elements is a temperature sensor.
15) The magnetic field sensor array of any preceding embodiment, wherein each temperature sensor is integrated with a different one of the plurality of magnetic field sensors, in particular with a number of temperature sensors equaling a number of magnetic field sensors.
16) A method for determining a magnetic field around an object, in particular created by said object, comprising the steps of:
   a) placing the object onto or near a surface of a magnetic field sensor array, in particular a magnetic field sensor array according to one of the preceding embodiments, said magnetic field sensor array comprising a plurality of magnetic field sensors;
   b) obtaining an image showing at least a part of the object and at least a first subset of the magnetic field sensors, in particular by means of an optical camera;
   c) determining a position and/or orientation of the object relative to the magnetic field sensor array based on the image;
   d) measuring a magnetic field distribution with the magnetic field sensor array.
17) The method of embodiment 16, wherein to determine the position and/or orientation of the object, the image is analyzed to identify a second subset of magnetic field sensors which are obstructed from the optical camera's view by the object.
18) The method of embodiment 16 or 17, wherein the object is placed between the magnetic field sensor array and the optical camera.
19) The method of any preceding method embodiment, wherein the magnetic field sensor array and the optical camera are positioned on opposite sides with respect to the object.
20) A method for determining a magnetic field around an object, in particular created and/or generated by said object, comprising the steps of:
   a) placing the object onto or near a surface of a magnetic field sensor, in particular a magnetic field sensor array according to one of embodiments 1 to 15;
   b) illuminating the object and the magnetic field sensor with a light source, in particular a mapping light source;
   c) determining a first intensity distribution, in particular a first intensity distribution at or near a surface layer of a semiconductor substrate comprised by the magnetic field sensor;
   d) determining a position and/or orientation of the object relative to the magnetic field sensor array based on the first intensity distribution;
   e) measuring a magnetic field distribution with the magnetic field sensor.
21) The method of embodiment 20, wherein the magnetic field sensor is a or comprises a magnetic field sensor array, in particular a magnetic field sensor array according to one of the preceding embodiments, and/or with said magnetic field sensor array in particular comprising a plurality of magnetic field sensors, in particular Hall sensors.
22) The method of embodiment 20, wherein the magnetic field sensor comprises:
   a) a magnetic field sensitive optical element, in particular layer, configured to generate a photocurrent and/or an electromagnetic radiation, wherein
      i) the photocurrent and/or an electromagnetic radiation is dependent on and/or varies with the magnetic field;
      ii) the magnetic field sensitive optical element is provided in proximity to the semiconductor substrate, in particular the surface layer of the semiconductor substrate;
      iii) the semiconductor substrate is configured to measure the photocurrent and/or electromagnetic radiation generated by the magnetic field sensitive optical element, in particular to determine a spatial distribution of said photocurrent and/or electromagnetic radiation.
23) The method of embodiment 22, wherein the semiconductor substrate comprises a plurality of photodetectors, in particular photodiodes or an image sensor, in particular a CMOS or CCD image sensor comprising a plurality of pixels.
24) The method of embodiment 22 or 23, wherein the magnetic field sensitive optical comprises a layer consisting of or comprising a crystalline structure having at least one defect, wherein the crystalline structure is diamond, silicon (Si) or SiC, and the defect a colour center, in particular a nitrogen defect and/or a nitrogen-vacancy center, and with said layer preferably being provided adjacent to, adjoining and/or in direct contact with th semiconductor substrate.
25) The method of any preceding method embodiment, wherein
   a) the first intensity distribution is obtained while the light source is operated at a first, relatively higher output level of the light source, in particular a maximum output level;
   b) a second intensity distribution is obtained while the light source is operated at a second, relatively lower output level of the light source, in particular a minimum or zero output level, and/or is obscured; wherein
   c) the position of the object relative to the magnetic field sensor array is based on the first intensity distribution in combination with the second intensity distribution; in particular on a difference between the first intensity distribution and the second intensity distribution.
26) The method of any preceding method embodiment, wherein a known geometry of the object is taken into account in determining the position and/or orientation of the object relative to the magnetic field sensor, in particular the magnetic field sensor array.
27) The method of any of method embodiments 20, 21, or 25 to 26 in combination with 20 or 21, wherein the object is placed on the protection layer, preferably with a detachable protective foil interposed between the object and the protection layer.
28) The method of any preceding method embodiment, wherein
   a) the object is placed on an object support, in particular an at least approximately horizontal object support surface; and
   b) the magnetic field sensor, in particular the magnetic field sensor array, is mounted above the object support, in particular at a known distance from the object support, and/or with a surface of the magnetic field sensor, in particular of an at least partially transparent protection layer comprised by the magnetic field sensor, at least approximately parallel to the object support surface.
29) The method of the preceding embodiment, wherein a light source is integrated with the object support, wherein, in particular, the object support surface is a light emitting surface, in particular configured to emit diffuse light.
30) The method of any preceding method embodiment, further comprising correlating the position and/or orientation of the object relative to the magnetic field sensor, in particular the magnetic field sensor array, with magnetic field distribution as measured with the magnetic field sensor, in particular the magnetic field sensor array.
31) The method of any preceding method embodiment, further comprising providing a dataset representative of the magnetic field distribution relative to object, in particular
   a) to one or more surfaces, edges, corners, and/or a center of gravity of the object, and/or
   b) to one or more markers, in particular fiducials, provided on the object.
32) The method of any preceding method embodiment, further comprising the step of generating a 2-dimensional graphical representation of the magnetic field in which an indication of the position and/or orientation of the object is provided, in particular as an overlay.
33) The method of any of embodiments 20, 21, or 25 to 32 in combination with 20 or 21, wherein the magnetic field sensor is a magnetic field sensor array according to one of embodiments 9 to 15, and the first intensity distribution is determined by means of the plurality of light sensitive elements.
34) The method of any of embodiments 20 to 33, wherein the first and/or second intensity distribution is determined by evaluating signals from at least a subset of the magnetic field sensors, or from the plurality of photodetectors or the image sensor comprised by the semiconductor substrate.
35) The method of any of embodiments 20 to 34, wherein the first and/or second intensity distribution is used to determine which ones of the plurality of magnetic field sensors, the plurality of photodetectors or which pixels of the image sensor comprised by the semiconductor substrate are completely obstructed from illumination by the light source, in particular the mapping light source, by the object.
36) The method of any of embodiments 20, 21, or 25 to 35in combination with 20 or 21, wherein the first and/or second intensity distribution is used to determine which ones of the plurality of magnetic field sensors are unobstructed from illumination by the light source.
37) The method of any of embodiments 20 to 35, wherein the first and/or second intensity distribution is used to determine for which ones of the plurality of magnetic field sensors, the plurality of photodetectors or which pixels of the image sensor comprised by the semiconductor substrate illumination by the light source, in particular the mapping light source, is not obstructed through or by the object.
38) The method of any of embodiments 20 to 37, wherein the first and/or second intensity distribution is used to determine which ones of the plurality of magnetic field sensors, the plurality of photodetectors or which the pixels of the image sensor comprised by the semiconductor substrate are partially obstructed from illumination by the light source, wherein, in particular, it is determined for each partially obstructed sensor, photodetector or pixel what percentage of a surface area of said sensor, photodetector or pixel, respectively, is obstructed by the object.
39) Use of a magnetic field sensor array or a magnetic field camera, in particular for measuring a magnetic field distribution, said magnetic field sensor array or magnetic field camera comprising:
   a) a semiconductor substrate;
   b) a plurality of magnetic field sensors, in particular Hall sensors, provided on and/or within a surface layer of the semiconductor substrate;
   c) to determine an intensity distribution of a radiation, in particular electromagnetic radiation, in particular light from the UV-A, visible and/or near-infrared spectral ranges, impinging onto the surface layer of the semiconductor substrate.
40) Use of a magnetic field sensor array or a magnetic field camera according to any preceding use embodiment, wherein the intensity distribution is determined by evaluating signals from at least a subset of the magnetic field sensors.
41) Use of a magnetic field sensor array or a magnetic field camera according to any preceding use embodiment, wherein an intensity of the radiation varies or is varied overtime, and the intensity distribution is determined by evaluating a variation of the signals from at least a subset of the magnetic field sensors over time.
42) Use of a magnetic field sensor array or a magnetic field camera according to any preceding use embodiment, wherein
   a) the first set of signals from at least a subset of the magnetic field sensors is obtained while the radiation is at a first, relatively higher intensity level, in particular a maximum intensity level;
   b) a second set of signals from at least the subset of the magnetic field sensors is obtained while the radiation is at a second, relatively lower intensity level of the light source, in particular a minimum or zero output level, and/or is obscured; wherein
   c) the intensity distribution is determined by evaluating a change and/or difference between the signals in the first and second set.
43) A magnetic field camera comprising a magnetic field sensor array according to one of embodiments 1 to 15.

A magnetic field sensor array as described, in particular, in embodiments 1) to 15) as set forth above may comprise a plurality of magnetic field sensors integrated in and/or arranged or otherwise provided on a semiconductor substrate. The (individual) magnetic field sensors may in particular be Hall sensors but may also function according to different principles. In particular, some or all of the sensors may be coils, in particular pick-up coils, which may, in particular, produce a voltage in the presence of a time varying magnetic field.

More specifically, such magnetic field sensors may be configured to measure one or more spatial components of a (local) magnetic flux density, commonly denoted by vector quantity B, and sometimes also referred to as magnetic induction; and/or a variation or change of the magnetic flux density over time.

A Hall sensor (sometimes also called Hall effect sensor) generally comprises a sensor body made of an electrically conducting material, which sensor body may also be referred to as a Hall element, as exemplary described in Wikipedia-Article "Hall effect sensor" in its version of 03 April 2023 (available at https://de.wikipedia.org/w/index.php?title=Hall-Sensor&oldid=232440088). The electrically conducting material may in particular be a doped semiconductor material, preferably with a high electron mobility as e.g. provided by GaAs, InAs, InP, InSB, etc; and may in particular be provided as a doped region in the semiconductor substrate, in particular a surface layer of the semiconductor substrate.

To detect a magnetic field and/or measure a magnitude of a magnetic flux density with a Hall sensor, a current, sometimes also referred to as biasing current, is imposed to flow in the sensor body. When a sufficiently strong magnetic field is present, charge carriers providing said current are deflected due to Lo-rentz force, which will give rise to a voltage between to properly chosen points on the sensor body, said voltage, which would not be present in the absence of the magnetic field, is generally referred to as Hall voltage. In general, the voltage will at least approximately be linearly dependent on the magnitude of the magnetic flux density, in particular at least approximately proportional to the magnitude of the magnetic flux density but for an offset voltage (which may at least approximately be zero, in particular under ideal circumstances).

The magnetic field sensors may be integrated into and/or with electric or electronic circuitry provided in and/or on the same semiconductor substrate, which circuitry may comprise active and passive elements comprising, inter alia, interconnects, resistors, capacitors, inductors, transistors, amplifiers, signal processing elements, etc.

The plurality of magnetic field sensors may be arranged as a matrix or an array comprising *N* lines and *M* columns, where *N* = *M* may hold. Typical values for *N* and *M* may be 16 or larger, in particular 128, 256 or even larger. The arrangement may be regular and/or uniform, with a constant distance between two adjacent lines and/or columns of sensors. Alternatively, the arrangement may also be irregular. The plurality of magnetic field sensors may comprise two or more subsets of sensors, wherein the sensors within in each subset are identical, but different from the sensors from any other subset. In particular, a first subset may comprise so called lateral Hall sensors, which may comprise a Hall element that extends essentially parallel to a surface and/or the surface layer of the semiconductor substrate, in particular with a depth or thickness of the Hall element in a direction perpendicular to the surface and/or the surface layer being much smaller than both a width and a length of the Hall element in directions parallel to the surface and/or the surface layer. Lateral Hall sensors may, in particular, be configured to measure magnetic fields and/or magnetic field components in directions at least essentially perpendicular to the surface and/or the surface layer of the semiconductor substrate. A second subset may, in particular, comprise vertical Hall sensors, which may in particular be configured to measure magnetic fields and/or magnetic field components in directions at least essentially parallel to the surface and/or the surface layer of the semiconductor substrate.

The plurality of magnetic field sensors of the magnetic field sensor array may be employed to measure and/or capture a (spatial) magnetic field distribution, wherein one or more quantities characterizing the (local) magnetic field at each of the sensors may be measured at least essentially simultaneously. The one or more quantities may in particular comprise (spatial) components of the (local) magnetic flux density vector. The magnetic field sensor array may thus be used as a or as part of a magnetic field camera. As the surface and/or the surface layer of the semiconductor substrate are, at least in general, at least essentially planar, such a magnetic camera may, in particular, measure and/or capture a two-dimensional, planar magnetic field distribution.

In accordance with the invention, an at least partially transparent protection layer may be provided to cover the plurality of magnetic field sensors. Such a protection layer me, in particular, be provided or formed on or above the semiconductor substrate, in particular on or above the surface layer of the semiconductor substrate, and may be of adequate size and shape to cover all the magnetic field sensors comprised by the magnetic field sensor array.

The at least partially transparent protection layer may allow for the plurality of magnetic field sensors - or at least a subset thereof- and/or other structures, features, elements etc., which may be arranged or otherwise provided on the semiconductor substrate, in particular on or in the surface layer of the semiconductor substrate, to remain visible, in particular to optical detection and/or inspection, in particular by means of an optical camera. Such an optical camera may be configured to deliver images obtained by it, and showing at least a subset of the plurality of magnetic field sensors and/or said other structures, features, elements etc., to an image processing system, unit, etc. This may significantly facilitate a determination and/or establishment of a (spatial) correlation between a magnetic field measured and/or captured using the magnetic field sensor array and a position, orientation, shape and/or geometry of an object, in particular a magnet, generating said magnetic field. The at least partially transparent protection layer may be of sufficient optical quality to allow for a sufficient visibility at the subset of the plurality of magnetic field sensors and/or said other structures, features, elements etc. In particular, it may be sufficiently homogenous, uniform, planar, thin, and/or have sufficiently smooth and parallel front and back surfaces.

The at least partially transparent protection layer may comprise or be made from tempered Glass as exemplary described in Wikipedia article
https://en.wikipedia.org/w/index.php?title=Tempered glass&oldid=1162627401, and/or from Gorilla Glass^{™} as exemplary described in Wikipedia article
https://en.wikipedia.org/w/index.php?title=Gorilla Glass&oldid=1167611796. It may also comprise or be made from polycarbonate.

For the plurality of magnetic field sensors - or at least a subset thereof - and/or other structures, features, elements etc. to be visible, in particular to optical detection and/or inspection, the magnetic field sensor array or any magnetic field camera in which it may be deployed should be free of any opaque layers or other opaque elements in front of and/or above the semiconductor substrate, in particular the plurality of magnetic field sensors. In particular, such layer or objects should not be present either below or behind the protection layer, nor above or in in front of it. Likewise, if the protection layer is only partially transparent, the magnetic field sensor array or any magnetic field camera in which it may be deployed should be free of any partially transparent layers or other partially transparent elements in front of and/or above the semiconductor substrate, which together with the partially transparent protection layer effectively form an at least essentially opaque element or layer.

For optimum protection, the at least partially transparent protection layer may be permanently attached to the semiconductor substrate and/or the surface layer. In particular, the at least partially transparent protection layer may be glued, bonded, cemented to the surface layer and/or the semiconductor substrate, in particular by means of a transparent adhesive.

Alternatively or in addition, the semiconductor substrate and the at least partially transparent protection layer may be cast together or potted together, in particular using a polymer, in particular an epoxy resin, which preferably remains at least partially transparent after curing. The polymer, together with the at least partially transparent protection layer, may thus form and/or provide an encapsulation which seals the plurality of magnetic field sensors and/or the surface layer and any further features possibly provided thereon off against an environment.

In certain embodiments, the at least partially transparent protection layer may be provided by a cast layer in itself. This may, in particular, be achieved by casting a polymer layer, in particular an epoxy resin layer, over at least the plurality of magnetic field sensors, and subsequently curing and/or hardening said polymer layer.

The at least partially transparent protection layer may only be transparent to wavelengths, in articular one or more isolated wavelengths, from one or more wavelength bands, and may be at least essentially opaque to other wavelengths, in particular wavelengths from outside said one or more wavelength bands.

Said wavelength bands may, in particular, be subranges of wavelengths from a UV-A, visible and/or near-infrared spectral range. Bands and/or subranges may be relatively narrow, and only extend over a single up to a few nanometers. This may, in particular, be achieved by providing an interference filter as or as part of the partially transparent protection layer.

Alternatively or in addition, a maximum transparency of the partially transparent protection layer in the UV-A, visible and near-infrared spectral ranges may be limited at 80%, preferably 50%, and most preferably 20%. More specifically, a maximum of a transmittance or transmission coefficient of the at least partially transparent protection layer within the UV-A, visible and near-infrared spectral ranges may be 0.8, preferably 0.5, and most preferably 0.2, wherein the transmittance and/or transmission coefficient may, in particular, be defined as respectively described in Wikipedia articles
https://en.wikipedia.org/w/index.php?title=Transmittance&oldid=1105538040 and
https://en.wikipedia.org/w/index.php?title=Transmission coefficient&oldid=1114311821.

A limited and/or restricted transparency may have advantages at least for certain configurations and/or under certain conditions, as will be explained in more detail below.

At least a some of the magnetic field sensors may comprise, in particular be marked with, a unique, visible identifier, wherein each identifier is different from any other identifier. Each visible identifier may comprise a symbol, in particular a combination of symbols, each of which may in turn comprise digits, numbers and/or letters. The unique identifiers may, in particular, be (consecutive) numbers. All identifiers may have, in particular consist of, the same number of symbols, in particular the same number of digits, numbers and/or letters.

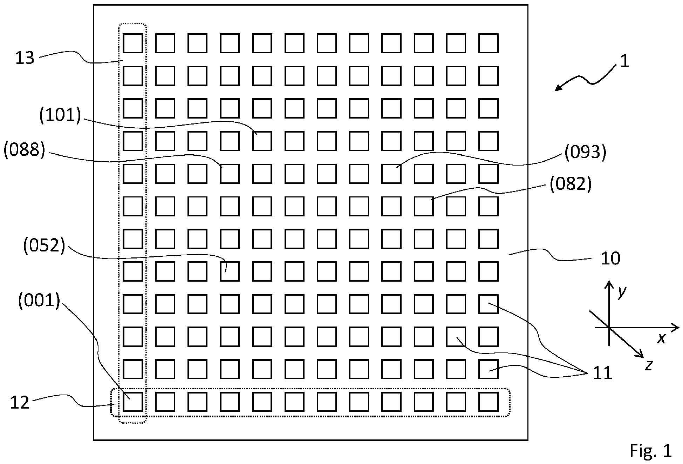

Fig. 1 shows a top view of an exemplary magnetic field sensor array 1, as seen when looking onto the surface layer of the semiconductor substrate 10 through the at least partially transparent protection layer (which is thus not shown in Fig. 1), i.e. in a direction corresponding to a -*z*-direction as indicated in Fig. 1. A total of 144 magnetic field sensors 11 are arranged in a regular array comprising N = 12 lines and *M* = 12 columns, extending respectively in +*x*- and +*y*-directions. Lines and columns may be consecutively numbered using indices *n* and *m*, respectively, and beginning with *n* = 1 for the bottommost line 12, and *m* = 1 for the leftmost column 13. The magnetic field sensors may then be numbered using an index *s*, which may be defined according to s = 12 (*n* -1) + *m*. Said index may be reproduced (not shown in Fig. 1) on or next to at least some, in particular each, magnetic field sensor(s), e.g. in a three-digit format. For illustration, magnetic field sensors with 001, 052, 082, 088, 093 and 101 are identified in Fig. 1 (wherein the index s is reproduced in parentheses to avoid confusion with reference signs).

**A method in accordance with a first basic embodiment** of the invention for determining a magnetic field around an object in accordance with a first basic embodiment of the invention, as in particular set forth in numbered embodiments 16 to 19 above, may comprise the steps of:
a) placing the object onto or near a surface of a magnetic field sensor array, in particular a magnetic field sensor array according to one of embodiments 1 to 15 as detailed above, said magnetic field sensor array comprising a plurality of magnetic field sensors;
b) obtaining an image showing at least a part of the object and a first subset of the magnetic field sensors, in particular by means of an optical camera;
c) determining a position and/or orientation of the object relative to the magnetic field sensor array based on the image;
d) measuring a magnetic field distribution with the magnetic field sensor array.

The magnetic field may be created by the object, which may be a magnetic system as described initially, and/or, in particular, a permanent magnet or an electromagnet. The object may be brought into a vicinity of the magnetic field sensor array, in particular a surface of the magnetic field sensor array. More specifically, the object may be brought into physical contact with, in particular be placed on the surface of the magnetic field sensor array. If the magnetic field sensor array is a magnetic field sensor array according to one of embodiments 1 to 15 further above, the object may be placed on or onto the protection layer, wherein with a detachable and/or replaceable protective foil may be interposed between the object and the protection layer. Alternatively, the object may be placed onto and held in place by a support, which may in particular be configured to fix and/or support the object in a defined position relative to the magnetic field sensor array, in particular at a defined distance from the latter.

Once the object is in place, an image may be captured by means of an optical camera such that said image shows at least a part of the object, and at least some of the plurality of magnetic field sensors. Preferably, the image may show the whole object and all the magnetic field sensors that are not obstructed from the optical camera's view by the object.

The optical camera, may, in particular be positioned opposite the magnetic field sensor array, in particular with an image plane of the optical camera at least essentially parallel to the surface layer of the semiconductor substrate and/or the at least partially transparent protection layer, in particular a surface of said at least partially transparent protection layer, said surface facing away from the semiconductor substrate; with the object located between the camera, in particular the image plane, and the magnetic field sensor array; and/or with an optical axes of the camera extending through the object.

The optical camera may, in particular, be equipped with a telecentric lens as exemplary described in Wikipedia article
https://en.wikipedia.org/w/index.php?title=Telecentric_lens&oldid=1126854072, and/or may in particular be configured to produce an image which is an orthographic projection of the object and the magnetic field sensor array, or at least of the portions imaged thereof, as exemplary described in Wikipedia article https://en.wikipedia.org/w/index.php?title=Orthographic_projection&oldid=1148760590.

From the image, a position and/or orientation of the object relative to the magnetic field sensor array may be determined.

To simplify the determination of the position, at least a some of the magnetic field sensors may be marked with a unique, visible identifier as described above. To avoid any potential mixing up of identifiers, in particular when (automated) image processing means are employed to analyze the image, all identifiers may have, in particular consist of, the same number of symbols, in particular the same number of digits, numbers and/or letters. This may, in particular, avoid confusion when one or more identifiers are partially obstructed from the optical camera's view by the object and/or the support.

An approximate position, in particular with respect to *x*- and *y*-directions, and/or orientation may rapidly and efficiently be determined by determining which magnetic field sensors from the magnetic field sensor array are obstructed from the optical camera's view by the object, and which ones are not. If all the sensors comprise a unique, visible identifier, a respective process may easily be simplified and/or automized by means of image processing algorithms and/or an image processing system or unit employing such algorithms. Applying these, the image may be searched for identifiers, in particular numbers, the identifiers found are extracted and aggregated in a list or a table, which list or table may then be compared with another list or table comprising all know and/or used identifiers. In particular, if the identifier comprises only numbers, digits and/or text symbols, optical character recognition (OCR) methods as, for example, described in Wikipedia article https://en.wikipedia.org/w/index.php?title=Optical character recogni-tion&oldid=1167300974 may be employed to search for, find, and/or extract the identifiers.

In a specialized and/or industrial production or manufacture of magnets and/or magnetic systems, geometry and/or dimensions of the object are generally known with high accuracy and/or well-defined tolerances. Respective data and/or information may be employed in determining the position and/or orientation, in particular to speed up a determination of the approximate position and/or orientation, and/or enhance an accuracy of said determination.

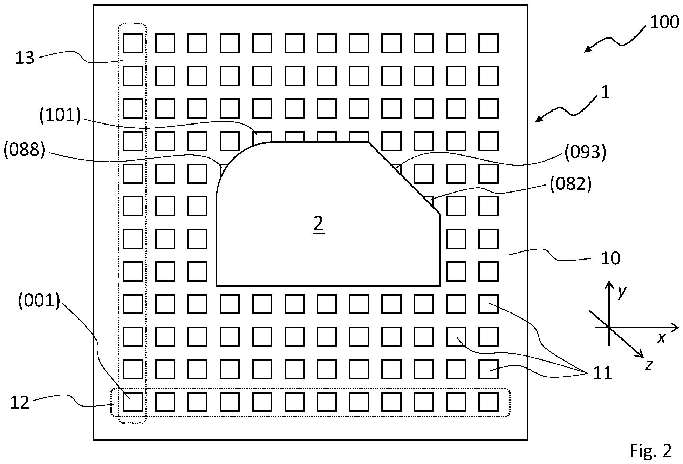

Fig. 2 illustrates an exemplary image 100 of an object 2 placed on the magnetic field sensor array 1, in particular on semiconductor substrate 10 as may be obtained by means of an optical camera. As may be seen, magnetic field sensors numbered 052 to 058, 064 to 070, 078 to 081, and 089 to 092 are completely obstructed from the optical camera's view by object 2, and thus not visible in the image. Magnetic field sensors 082, 088, 093, and 101 to 104 are partially obstructed, so that a portion of each of said latter sensors remains visible in the image.

As a non-limiting example, simulations may be carried out, in particular on a computer which may employ ray-tracing methods, algorithms and/or software as exemplary described in Wikipedia article https://en.wikipedia.org/w/index.php?title=Ray_tracing_(physics)&oldid=1149518029, to determine, from the data and or information on the known geometry and/or dimensions of the object, and, in particular, information, in particular parameters, regarding the illumination and/or the light source, an expected image for each of a plurality of hypothetical positions and/or orientations of the object 2. An actual image obtained by the optical camera may then be compared with each of the plurality of expected images and a difference and/or deviation be determined and/or measured. An actual position and/or orientation of the object may then be assumed to correspond to that hypothetical position and/or orientation of the object for which the difference and/or deviation is smallest as compared to the expected images for all other hypothetical positions and/or orientations.

A method in accordance with a second basic embodiment of the invention for determining a magnetic field around an object, as in particular set forth in numbered, above embodiments 20, 21, and 25 to 38 in as far the latter refer to any one of the former , may comprise the steps of:
a) placing the object onto or near a surface of a magnetic field sensor;
b) illuminating the object and the magnetic field sensor array with a light source;
c) determining a first intensity distribution, in particular a first intensity distribution at or near a surface layer of a semiconductor substrate comprised by the magnetic field sensor;
d) determining a position and/or orientation of the object relative to the magnetic field sensor based on the first intensity distribution;
e) measuring a magnetic field distribution with the magnetic field sensor.

In the method in accordance with the second basic embodiment, the magnetic field sensor may be a or comprise a magnetic field sensor array, in particular a magnetic field sensor array according to one of the respective embodiments as set forth above.

More specifically, a method for determining a magnetic field around an object in accordance with a second basic embodiment of the invention may comprise the steps of:
a) placing the object onto or near a surface of a magnetic field sensor array according to one of the respective embodiments as set forth above;
b) illuminating the object and the magnetic field sensor array with a light source;
c) determining a first intensity distribution, in particular a first intensity distribution at or near the surface layer of the semiconductor substrate;
d) determining a position and/or orientation of the object relative to the magnetic field sensor array based on the first intensity distribution;
e) measuring a magnetic field distribution with the magnetic field sensor array.

This method variant has the advantage that no separate or external optical camera is required to determine the position and/or orientation of the object relative to the magnetic field sensor array, by making use of the fact that the object, when placed close to the magnetic field sensor array, in particular in physical contact with the magnetic field sensor array, will cast a shadow onto the magnetic field sensor, and/or at least partially obscure and/or obstruct an illumination and/or environmental lighting.

Since semiconductor materials like e.g. silicon are sensitive to light, the magnetic field sensor array may also function as a replacement for an optical camera. Each pixel may accordingly contain light-sensitive components that produce a grayscale image resembling the object captured by the magnetic field sensor array and/or magnetic camera consisting of or comprising said array. Essentially, optical means are used to measure the object's shadow. By illuminating the object appropriately, its shadow can provide accurate information about its size, position, and orientation.

In manufacturing scenarios, one typically only needs to determine the object's geometric position, and often the ideal shape of the object is already known. Therefore, a low-resolution image may be sufficient to ascertain the object's position and orientation sufficiently precisely. For instance, the light-sensitive elements in each pixel can be photodiodes or even temperature sensors. To enhance the contrast of the signal, it may be necessary to employ a controlled light source and measure the difference between images captured with the light turned on and off.

There are two advantages to utilizing the magnetic camera as replacement for an optical camera:
Firstly, there is no need to install a separate optical camera since the magnetic camera can serve both purposes. This eliminates the requirement for additional equipment and simplifies the setup.
Secondly, there is no necessity to separately correlate the optical image with the magnetic image. Both images are captured within the same coordinate system, ensuring the measurements are inherently aligned. Consequently, the system's design already ensures that the measurements from both the optical and magnetic perspectives are fully synchronized, eliminating the need for any further alignment or correlation procedures.

Illumination may, in particular, be provided in the form of a collimated beam, that may be directed at least essentially parallel to a surface normal of a surface of the semiconductor substrate and/or the at least partially transparent protection layer.

In particular, when the object is located on the surface of the magnetic field sensor array, in particular on the protection layer, a diffuse lighting and/or illumination may also be used.

A light source for providing such illumination, may, in particular be positioned opposite the magnetic field sensor array, with the object located between the light source and the magnetic field sensor array.

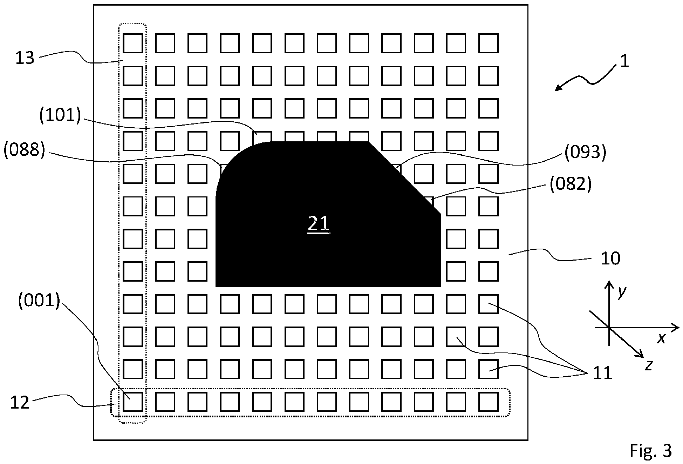

Fig. 3 illustrates an intensity distribution on the surface of the semiconductor substrate 10 for an exemplary situation where object 2 (not shown in Fig. 3) is placed directly on the surface of the magnetic field sensor or the at least partially transparent protection layer. Under collimated or diffuse illumination/lighting as described above, the presence of the object gives rise to a shaded area 21 in which the intensity is at least essentially equal to zero. Outside said shaded are 21, light from the illumination and/or lighting will reach the surface of the semiconductor substrate 10 at least essentially unobstructed by the object 2, so that intensity in this area will be given by an intensity of the illumination and/or lighting - as transmitted by a partially transparent protection layer if such a layer is present. The shaded area 21 is thus indicative of the position and/or orientation of the object relative to the magnetic field sensor array.

As may be seen from Fig. 3, magnetic field sensors numbered 052 to 058, 064 to 070, 078 to 081, and 089 to 092 are completely obstructed and/or shaded off from illumination by object 2. Thus, essentially no light at all from any illumination source will reach said sensors.

The method in accordance with the second basic embodiment of the invention may, in particular, be carried out in a first variant using a magnetic field sensor array according to one of embodiments 9 to 15 as set forth above, wherein the plurality of light sensitive elements may be used to determine, in particular measure, the first light intensity distribution, from which in turn information on a position and/or orientation of the shadow and/or an area of the magnetic field sensor array obscured by the object may be obtained and/or derived.

The method may, however, also be carried out using a magnetic field sensor array without any dedicated and/or specific light sensitive elements, in particular with a magnetic field sensor array free of photodetectors, photodiodes and/or CCD cells.

In a second variant of the method in accordance with the second basic embodiment of the invention, this may be done by using temperature sensors to determine the first intensity distribution. Temperature sensors may be provided with at least some, in particular all, of the magnetic field sensors. As a characteristic of Hall sensors is generally temperature dependent, at least a single temperature sensor is provided as part of most magnetic field sensor arrays comprising or made up of Hall sensors. Highly accurate Hall sensor arrays generally comprise one temperature sensor for each Hall sensor, wherein each temperature sensor may in particular be arranged closely, in particular as closely as physically possible, to a sensor body and/or the Hall element of each respective Hall sensor. The temperature sensors may be semiconductor temperature sensors, and may be integrated with the semiconductor substrate of the magnetic field sensor array and/or the electric or electronic circuitry, both in accordance with the principles as set forth in Wikipedia article
https://de.wikipedia.org/w/index.php?title=Temperatursensor&oldid=233732527.

It has been observed that typical semiconductor temperature sensors also react to illumination, in particular with near-infrared radiation, but also with light from the visible and/or near UV-A spectrum if an intensity of the illumination is sufficiently high.

The first intensity distribution may thus be determined based on the signals, in particular ordinary signals, delivered by the temperature sensors under adequate illumination conditions, wherein said signals may, in particular, be regarded as intensity signals, possibly containing an at least essentially constant and/or uniform offset. An appropriate illumination wavelength or wavelength range or ranges and a sufficient illumination intensity may easily be determined by a person skilled in the art by way of experimentation. In respective experiments, a dependence of ordinary signals provided by the temperature sensors to changing illumination wavelength, wavelength range and/or intensity may be observed, wherein, in particular, any other parameters and/or environmental influence factors may be left unchanged. In the present context, the term "ordinary signal(s)" of a sensor may be understood to refer to such signal(s) and/or measurements as are normally considered indicative of a quantity the sensor is destined to sense and/or measure, and/or analyzed and/or otherwise evaluated to determine and/or obtain such quantity. An ordinary signal of a temperature sensor may thus in particular be a temperature signal or measurement.

When carrying out experiments to refine the second variant of the method as described above, it has been found with surprise that the Hall sensors themselves exhibit a light sensitivity which may be sufficiently strong to determine the first intensity distribution with sufficient accuracy from measurements with the magnetic field sensors themselves. In a third variant of the second basic embodiment, the first intensity distribution may in particular be determined based on signals, in particular ordinary signals, provided by the plurality of magnetic field sensors under illumination/lightning. An ordinary signal of a Hall sensor may accordingly be a magnetic field signal or measurement. The signals may, in particular, be regarded as intensity signals, possibly containing an at least essentially constant and/or uniform offset.

A light sensitivity of a temperature sensor or a Hall sensor may be determined by observing and/or determining how much an ordinary signal, in particular an amplitude thereof, provided by the respective sensors changes when an intensity and/or amplitude of the illumination changes by one or more known amounts or factors. The light sensitivity may then be defined as a ratio of the change(s) in signal relative to the change(s) in illumination intensity and/or amplitude. Light sensitivities of both temperature sensors and Hall sensor will in general significantly depend on a wavelength or wavelength range or distribution of the illumination, and may accordingly be determined for a plurality of wavelength and/or wavelength ranges. Light sensitivity may, in particular, be expressed as a function of wavelength.

In semiconductor sensor arrays as described above, the at least partially transparent protection layer may have a maximum transmittance and/or transmission coefficient at a wavelength or in a wavelength range for which a light sensitivity of the temperature sensors and/or Hall sensors is significantly smaller than a maximum light sensitivity, in particular a maximum of the light sensitivity within the UV-A, visible and/or near-infrared spectral ranges. Alternatively or in addition, a transmittance and/or transmission coefficient at a wavelength or in a wavelength range for which a light sensitivity of the temperature sensors and/or Hall sensors is at a maximum may be significantly smaller than a maximum transmittance and/or transmission coefficient of the at least partially transparent protection layer. This may, inter alia, reduce a negative impact of ambient light from the UV-A, visible and/or near-infrared spectral ranges on temperature and/or magnetic field measurements.

An approximate position and/or orientation of the object may rapidly and efficiently be determined by determining for which magnetic field sensors from the magnetic field sensor array illumination is obstructed by the object, and for which ones it is not.

In particular in combination with the third variant, this determination may be carried out directly on the intensity distribution as determined based on signals, in particular ordinary signals, provided by the plurality of magnetic field sensors. In particular, no spatial offset needs to be accounted for, as may, in particular, be the case with the first variant due to the fact that the light sensitive elements need to be provided apart from the magnetic field sensors for elementary reasons. An analogous approach may be taken for the second variant, when a distance between magnetic field sensors and respective, associated temperature sensors may be neglected.

As may be seen from Fig. 3, magnetic field sensors 082, 088, 093, and 101 to 104 are partially obstructed and/or shaded off. Under illumination/lighting, said sensors will thus receive some light, albeit with an amount of light reduced as compared to completely unobstructed sensors like, e.g. 001, 0051, 083, 087, etc. It was found that this has the effect that the partially obstructed sensors see an effectively reduced intensity/amplitude as compared to fully unobstructed sensors, wherein a degree and/or amount of reduction is indicative of, in particular corresponds at least approximately to, what percentage of a surface area of a partially obstructed sensor is obstructed by the object.

In particular when illumination is sufficiently uniform, it is thus possible to determine for each sensor whether it is completely obstructed and/or shaded off from illumination by object 2, completely unobstructed, or partially obstructed and/or shaded off from illumination by object 2, wherein in the latter case, a percentage of the surface area of the respective sensor which is obstructed.

Knowledge of which sensors are partially obstructed, in particular together with knowledge of what percentage of a respective surface area of each of said sensors, may be used to enhance an accuracy of the determination of the position and/or orientation of the object.

As a sensitivity of temperature and/or magnetic field sensors to illumination with wavelengths from the UV-A, visible and/or near-infrared spectral range may be low, a second intensity distribution may be obtained with different illumination conditions present, in particular without illumination. A differential intensity distribution may then be obtained by subtracting the first intensity distribution from the second intensity distribution or vice versa. The differential intensity distribution may have significantly enhanced contrast, as the difference in illumination level or obscuring the illumination will only affect temperature sensors or magnetic field sensors not fully obstructed by the object. As such, the differential intensity distribution may in particular allow for a more accurate determination of what percentage of the surface area of a partially obstructed sensor is obstructed.

A respective process may again easily be simplified and/or automized by means of image processing algorithms and/or an image processing system or unit employing such algorithms. These may, in particular be applied to the first intensity distribution as obtained according to the second and third variants as described further above or to the differential intensity distribution, in particular to carry out a number of image corrections and/or enhancements, as for example offset correction, binarization, thresholding, sharpening (in particular of edges), smoothing (in particular of areas), and/or image analysis methods as for example image segregation, object recognition and/or localization, etc.

As already mentioned above, geometry and/or dimensions of the object are generally known with high accuracy and/or well-defined tolerances in a specialized and/or industrial production or manufacture of magnets and/or magnetic systems. Respective data and/or information may again be employed in determining the position and/or orientation, in particular to speed up a determination of the approximate position and/or orientation, and/or enhance an accuracy of said determination.

As a non-limiting example, simulations may be carried out, in particular on a computer which may employ ray-tracing methods, algorithms and/or software as exemplary described in Wikipedia article https://en.wikipedia.org/w/index.php?title=Ray tracing (physics)&oldid=1149518029, to determine, from the data and or information on the known geometry and/or dimensions of the object, and, in particular, information, in particular parameters, regarding the illumination and/or the light source, an expected position and/or orientation of the shaded area 21 for a plurality of hypothetical positions and/or orientations of the object 2. Alternatively or in addition, information on which sensors would be fully or partially obstructed, in particular together with knowledge of what percentage of a respective surface area of each of said sensors, and/or which ones are fully unobstructed, may be derived for each of the hypothetical positions and/or orientations of the object 2. An actual position and/or orientation of the shaded area 21, and/or knowledge of which sensors are actually fully or partially obstructed (and to what percentage), and/or which ones are fully unobstructed, may then be compared with respective expected data/information for each of the hypothetical positions and/or orientations of the object 2 and a difference and/or deviation be determined and/or measured. An actual position and/or orientation of the object may then be assumed to correspond to that hypothetical position and/or orientation of the object for which the difference and/or deviation is smallest as compared to all other hypothetical positions and/or orientations.

A method in accordance with a third basic embodiment of the invention for determining a magnetic field around an object, as in particular set forth in numbered embodiments 22 to 25 above and any embodiments referring thereto, may comprise the steps of:
a) placing the object onto or near a surface of a magnetic field sensor;
b) illuminating the object and the magnetic field sensor array with a light source, in particular a mapping light source;
c) determining a first intensity distribution, in particular a first intensity distribution at or near a surface layer of a semiconductor substrate comprised by the magnetic field sensor;
d) determining a position and/or orientation of the object relative to the magnetic field sensor based on the first intensity distribution;
measuring a magnetic field distribution with the magnetic field sensor.

The magnetic field sensor may, in particular, comprise a magnetic field sensitive optical element, in particular layer, configured to generate a photocurrent and/or an electromagnetic radiation, wherein
e) the photocurrent and/or an electromagnetic radiation is dependent on and/or varies with a magnetic field, in particular a magnetic flux density at or within the magnetic field sensitive optical element;
f) the magnetic field sensitive optical element is provided in proximity to the semiconductor substrate, in particular the surface layer of the semiconductor substrate;
g) the semiconductor substrate is configured to measure the photocurrent and/or electromagnetic radiation generate by the magnetic field sensitive optical element, in particular to determine a spatial distribution of said photocurrent and/or electromagnetic radiation.

The method in accordance with the third basic embodiment of the invention may in particular be applied when using magnetic field sensors and/or cameras as described in or based on the principles described in WO 2022/136175 A1 (cf., in particular, claims 1 and 10), albeit without necessarily making use of all features in any one of the claim, comprised by any one of the embodiments described, and/or of the teachings contained in said document. In contrast to the magnetic field sensor arrays of embodiments 1 to 15 and the method embodiments 20, 21 and the method embodiments as referring thereto, the semiconductor substrate of such magnetic field sensors and/or cameras in itself is, in general, not configured to determine magnetic fields, in particular magnetic flux densities, i.e. without the magnetic field sensitive optical element. In particular, the semiconductor substrate of such magnetic field sensors and/or cameras may be free of Hall-sensors and/or pick-up coils.

Accordingly, the magnetic field sensitive optical element may comprise or consist of a first material which, when subjected to a physical excitation and/or physical activation, generates a luminescence or a photocurrent, wherein said luminescence or photocurrent depends on the magnetic flux density. The semiconductor substrate, in turn, may comprise or constitute means for measuring the luminescence, in particular, but not necessarily, by means of a detection signal representing and/or reflecting the strength of the detected luminescence signal or photocurrent signal. Physical excitation may be provided electrically or electromagnetically, inter alia optically, in particular by illumination with an appropriate wavelength. Illumination for excitation purposes may also be referred to as excitation illumination and may, in particular, be provided by an excitation light source.

More specifically, the first material may comprise or be constituted by a crystalline structure having at least one defect, wherein the first material may, in particular, be diamond, silicon (Si) or SiC, and the defect a colour center - in particular as described in lines 8 to 25 on p. 5 of WO 2022/136175 A1 and the further references cited therein.

The magnetic field sensitive optical element may, in particular, consist of or comprise a layer of the first material, in particular a diamond layer having nitrogen defects and/or nitrogen-vacancy centers, which exhibits a luminescence which significantly depends on magnetic flux density (cf, WO 2022/136175 A1, p. 3, first paragraph), in particular decreases with increasing magnetic flux density. Excitation may efficiently be provided by excitation illumination with light having wavelengths between 500 and 600nm, while luminescence may occur at wavelengths between 600 and 800nm.

The semiconductor substrate may, in particular, comprise a photodetector, preferably a plurality of photodetectors, in particular (a) photodiode(s). More specifically, the semiconductor substrate may comprise an image sensor, in particular a CMOS image sensor or a charge-coupled device, CCD, image sensor.

The magnetic field sensitive optical element may be arranged in proximity to the semiconductor substrate, in particular on the semiconductor substrate, and/or the image sensor. Where the optical element is or comprises a layer of the first material, said layer may preferably be arranged in parallel to a surface of the semiconductor substrate and/or the image sensor, in particular with one or both surfaces of the layer at least essentially parallel to the surface of the semiconductor substrate and/or with the semiconductor substrate located on a first side of the layer. The layer and the semiconductor substrate may be arranged in a stacked fashion, and/or in such a way that the layer covers the plurality of photodetectors or the image sensor, preferably the entire image sensor. The optical element, in particular the layer, may be attached to the semiconductor substrate, in particular in a temporary, releasable and/or separable manner, which may, in particular, allow for the optical element or layer to be separated from the semiconductor substrate without damage to either of them.

Where the optical element is or comprises a layer of the first material, excitation illumination may, in particular, be applied laterally, in particular at and/or through one or more edges of the layer, rather than through one (or both) of the layer's surfaces, in particular by means of LEDs arranged one or more edges.

Attenuation means for preventing wavelengths other than those of the electromagnetic radiation generated by the magnetic field sensitive optical element, in particular due to luminescence as described above, may be provided between the optical element and the semiconductor substrate, and may, in particular, cover the plurality of photodetectors or the image sensor. Such means may in particular be configured to prevent light having wavelengths used for (optical) excitation of luminescence or photocurrent in the optical element from reaching the photodetectors or the image sensor.

With such an arrangement, the plurality of photodetectors or the image sensor may be used to capture an image or a spatial distribution of an intensity of the luminescence, which may be referred to as an activated intensity distribution or luminescence intensity distribution. Each signal provided by one of the plurality of the photodetectors or from a pixel of the image sensor may be regarded as a detection signal as mentioned above. The image or spatial distribution of the intensity of the luminescence may be considered representative of a spatial distribution of the magnetic field, in particular the magnetic flux density, within the layer of the first material, albeit with in inverse relation, i.e. with regions of relatively low intensities corresponding to regions with relatively strong magnetic field and vice versa.

A position and/or orientation of the object a magnetic field around which shall be determined may, in particular, be obtained in a manner following the principles as detailed in combination with the second basic embodiment of the invention as detailed above. Once the object has been placed or otherwise disposed on or near a surface of a magnetic field sensor, which surface may in particular be a surface of the magnetic field sensitive optical element, in particular of the layer which may constitute the optical element or be comprised by it, the object and the magnetic field sensor comprising the magnetic field sensitive optical element and the semiconductor substrate are illuminated by means of a light source. Where excitation is done optically, a light source other than the (excitation) light source used for excitation may advantageously be used, in particular a mapping light source. Illumination by a mapping light source may be referred to as mapping illumination to allow for better distinction from excitation illumination, at least in the general case when the two are different and/or separate.

(Mapping) illumination may, in particular, be provided in the form of a collimated beam, that may be directed at least essentially parallel to a surface normal of a surface of the semiconductor substrate, in particular the image sensor, and/or the layer which may constitute the optical element or be comprised by it. In particular, when the object is located on the surface of the layer or any further layer disposed on said former layer, diffuse lighting and/or illumination may also be used to advantage. A light source for providing such illumination, in particular a mapping light source, may, in particular, be positioned opposite the semiconductor substrate, with the object located between the light source and the magnetic field sensor array.

Mapping illumination may in particular employ wavelengths suitable for physical excitation and/or physical activation of the first material, and or corresponding to wavelengths generated by the first material following physical excitation, in particular when attenuation means as described above are present in the magnetic field sensor.

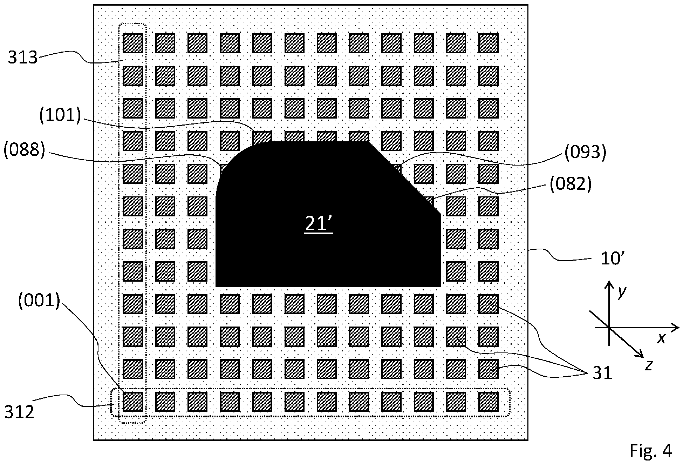

Fig. 4 illustrates an exemplary first intensity distribution on the surface of the semiconductor substrate 10' for an exemplary situation where object 2 (not shown in Fig. 4) is placed above, adjacent to and/or opposite the semiconductor substrate and/or the magnetic field sensitive optical element (not shown in Fig. 4). A plurality of pixels 31 is formed in the semiconductor substrate and arranged in lines and columns. A total of 144 pixels 31 are arranged in a regular array comprising *N* = 12 lines and *M* = 12 columns, extending respectively in +*x*- and +*y*-directions. Lines and columns may be consecutively numbered using indices *n* and *m*, respectively, and beginning with *n* = 1 for the bottommost line 312, and *m* = 1 for the leftmost column 313. The pixels may then be numbered using an index *s*, which may be defined according to *s* = 12 (*n* -1) + *m*. For illustration, pixels corresponding to indices 001, 052, 082, 088, 093 and 101 are identified in Fig. 4 (wherein each index *s* is reproduced in parentheses to avoid confusion with reference signs).

Under collimated or diffuse illumination/lighting as described above, the presence of the object gives rise to a shaded area 21' in which a first or obstructed intensity is at least essentially equal to zero. Outside said shaded area 21', light from the illumination and/or lighting will reach the surface of the semiconductor substrate 10 at least essentially unobstructed by the object 2, so that a second or unobstructed intensity in this area will be given by an intensity of the illumination and/or lighting - as possibly attenuated by the attenuation means or other means if present. The shaded area 21' is thus indicative of the position and/or orientation of the object relative to the magnetic field sensor array. Notably, the second or unobstructed intensity may at least partially be contributed to by luminescence, which may occur outside shaded area 21' when mapping illumination contains wavelengths capable of exciting electromagnetic radiation from the magnetic field sensitive optical element. Within shaded area 21', on the other hand, no luminescence is received in general.

An approximate position and/or orientation of the object may rapidly and efficiently be deter-mined by determining for which of the plurality of photodetectors or for which pixels of the image sensor illumination is obstructed by the object, and for which ones it is not.

As may be seen from Fig. 4, pixels numbered 052 to 058, 064 to 070, 078 to 081, and 089 to 092 are completely obstructed and/or shaded off from illumination by object 2. Thus, essentially no light at all from any illumination source will reach said sensors.

As may be seen from Fig. 4, pixels 082, 088, 093, and 101 to 104 are partially obstructed and/or shaded off. Under illumination/lighting, said pixels will thus receive some light, albeit with an amount of light reduced as compared to completely unobstructed sensors like, e.g. 001, 0051, 083, 087, etc. It was found that this has the effect that the partially obstructed pixels see an effectively reduced intensity/amplitude as compared to fully unobstructed pixels, wherein a degree and/or amount of reduction is indicative of, in particular corresponds at least approximately to, what percentage of a surface area of a partially obstructed pixels is obstructed by the object 2.

In particular when illumination is sufficiently uniform, it is thus possible to determine for each pixel whether it is completely obstructed and/or shaded off from illumination by object 2, completely unobstructed, or partially obstructed and/or shaded off from illumination by object 2, wherein in the latter case, a percentage of the surface area of the respective pixel which is obstructed.

Knowledge of which pixels are partially obstructed, in particular together with knowledge of what percentage of a respective surface area of each of said pixels, may be used to enhance an accuracy of the determination of the position and/or orientation of the object.

As an effective sensitivity of the plurality of photodetectors or the pixels of the image sensor to mapping illumination may be relatively low for various reasons that will be explained in more detail further below, a second intensity distribution may be obtained with different illumination conditions present, in particular without illumination. A differential intensity distribution may then be obtained by subtracting the first intensity distribution from the second intensity distribution or vice versa. The differential intensity distribution may have significantly enhanced contrast, as the difference in illumination level or obscuring the illumination will only affect pixels not fully obstructed by the object. As such, the differential intensity distribution may in particular allow for a more accurate determination of what percentage of the surface area of a partially obstructed sensor is obstructed.

A respective process may again easily be simplified and/or automized by means of image processing algorithms and/or an image processing system or unit employing such algorithms. These may, in particular be applied to the first intensity distribution, in particular to carry out a number of image corrections and/or enhancements, as for example offset correction, binarization, thresholding, sharpening (in particular of edges), smoothing (in particular of areas), and/or image analysis methods as for example image segregation, object recognition and/or localization, etc.

As already mentioned above, geometry and/or dimensions of the object are generally known with high accuracy and/or well-defined tolerances in a specialized and/or industrial production or manufacture of magnets and/or magnetic systems. Respective data and/or information may again be employed in determining the position and/or orientation, in particular to speed up a determination of the approximate position and/or orientation, and/or enhance an accuracy of said determination.

As already described further above, simulations may be carried out, in particular on a computer which may employ ray-tracing methods, algorithms and/or software to determine, from the data and or information on the known geometry and/or dimensions of the object, and, in particular, information, in particular parameters, regarding the illumination and/or the light source, an expected position and/or orientation of the shaded area 21 for a plurality of hypothetical positions and/or orientations of the object 2. Alternatively or in addition, information on which sensors would be fully or partially obstructed, in particular together with knowledge of what percentage of a respective surface area of each of said sensors, and/or which ones are fully unobstructed, may be derived for each of the hypothetical positions and/or orientations of the object 2. An actual position and/or orientation of the shaded area 21, and/or knowledge of which sensors are actually fully or partially obstructed (and to what percentage), and/or which ones are fully unobstructed, may then be compared with respective expected data/information for each of the hypothetical positions and/or orientations of the object 2 and a difference and/or deviation be determined and/or measured. An actual position and/or orientation of the object may then be assumed to correspond to that hypothetical position and/or orientation of the object for which the difference and/or deviation is smallest as compared to all other hypothetical positions and/or orientations.

As also described in WO 2022/136175 A1, the magnetic field sensor and/or camera may, in addition to the semiconductor substrate and the magnetic field sensitive optical element, comprise means for physical excitation integrally formed with the magnetic field sensitive optical element. Where the optical element is or comprises a (first) layer of the first material, such means may be provided on a second side of said layer, in particular opposite and/or across from the semiconductor substrate, and/or with said second side facing away from the semiconductor substrate, and may also consist of or comprise a (second) layer. Such means for means for physical excitation may, in particular, comprise an LED structure as described on p. 14 of WO 2022/136175 A1. The object a magnetic field around which shall be determined may then be placed adjacent to the means for physical excitation, in particular onto or on said means.

Means for physical excitation as described in the preceding paragraph may complicate mapping illumination, as they may substantially obstruct and/or absorb light emitted from the mapping light source, and thus reduce the effective sensitivity of the plurality of photodetectors or the pixels of the image sensor to mapping illumination. This may, e.g., be overcome by obtaining a differential intensity distribution as described further above.

This description and any accompanying drawings that illustrate aspects and embodiments of the present invention should not be taken as limiting the claims defining the protected invention. In other words, while the invention has been illustrated and described in detail in the drawings and foregoing description, such illustration and description are to be considered illustrative or exemplary and not restrictive. Various mechanical, compositional, structural, electrical, and operational changes may be made without departing from the spirit and scope of this description and the claims. In some instances, well-known circuits, structures and techniques have not been shown in detail in order not to obscure the invention. Thus, it will be understood that changes and modifications may be made by those of ordinary skill within the scope and spirit of the following claims. In particular, the present invention covers further embodiments with any combination of features from different and/or individual embodiments as described above and below. Embodiments in accordance with the invention may, in particular, include further and/or additional features, elements, aspects, etc. not shown in the drawings or described above.

The disclosure also covers all further features shown in any Figure, individually, although they may not have been described in the afore or following description. Also, individual alternatives of the embodiments described in any Figure and the description and individual alternatives of features thereof can be disclaimed from the subject matter of the invention or from disclosed subject matter. The disclosure comprises subject matter consisting of the features defined in the claims or the exemplary embodiments as well as subject matter comprising said features.

The present disclosure also includes embodiments with any combination of features which are mentioned or shown above and/or below, in various embodiments or variants. It also includes individual features as shown in the Figures, even if they are shown there in connection with other features and/or are not mentioned above or below. The disclosure comprises embodiments which exclusively comprise the features described in the claims or the exemplary embodiments, as well as those which comprise additional other features. The steps of any method disclosed above or claimed below may preferably be carried out according to the order in which they are presented, but may also be carried out in a different order.

Furthermore, in the claims the word "comprising" does not exclude other elements or steps, and the indefinite article "a" or "an" does not exclude a plurality. A single unit or step may fulfil the functions of several features recited in the claims. The mere fact that certain measures are recited in mutually different dependent claims does not indicate that a combination of these measures cannot be used to advantage. The terms "essentially", "substantially", "about", "approximately" and the like in connection with an attribute or a value particularly also define exactly the attribute or exactly the value, respectively. The term "about" in the context of a given numerate value or range refers to a value or range that is, e.g., within 20%, within 10%, within 5%, or within 2% of the given value or range. Components described as coupled or connected may be electrically or mechanically directly coupled, or they may be indirectly coupled via one or more intermediate components. Any reference signs in the claims should not be construed as limiting the scope.

Unless stated otherwise, it shall be assumed throughout this entire document that a statement *a* ≈ *b* may imply that |*a*-*b*|/(|*a*|+|*b*|) < 0.2, preferably |*a*-*b*|/(|*a*|+|*b*|) < 0.01, wherein *a* and *b* may represent arbitrary quantities, parameters and/or variables as described and/or defined anywhere in this document, or as otherwise known to a person skilled in the art. Further, a statement that a is at least approximately equal or at least approximately identical to *b* may imply that *a* ≈ *b,* and not exclude that *a* = *b.* Further, unless stated otherwise, throughout this entire document, a statement *a* ≫ *b* may imply that *a* > 5*b*, preferably *a* > 100*b*; and statement *a* ≪ *b* may imply that 5*a* < *b,* preferably 100*a* < *b.* A statement that a is significantly larger than b may imply that *a* ≫ *b.* A statement that *a* is significantly smaller than *b* may imply that *a* ≪ *b.*

Features, properties, etc. mentioned in the description but placed in parentheses may, but do not necessarily have to, be present and/or required, and are thus to be regarded as optional in principle. Such features, properties, etc. may serve the better understanding of the invention by hiding implicit, but non-essential aspects of the invention. Such features, properties, etc. may, in articular, be preferred and/or advantageous.

Unless specified otherwise, a connection, in particular between any two entities, including in particular nodes, points, terminals, elements, devices, etc. or combinations thereof, may refer to an electrically conductive connection, as in particular established by a wire, cable, busbar, a conductive track, trace or line on e.g. a (printed) circuit board, solder, etc. The electrically conductive connection is preferably at least substantially direct, in particular without any discrete elements, as, in particular, resistors, capacitors, inductors, or other passive or active elements or devices connected between the connected entities. The electrically conductive connection thus has at least essentially negligible resistance, capacitance and inductance, preferably at least essentially zero resistance, capacitance and inductance. In particular, resistance, capacitance and inductance of the electrically conductive connection are exclusively parasitic by nature. Further, resistance, capacitance and inductance of the electrically conductive connection significantly smaller (preferably by a factor of 1/100, 1/1000 or 1/10000) than resistances, capacitances and impedances of resistors, capacitors or inductors, respectively, connected by the electrical conductive connection, and/or comprised by an electric circuit or network which comprises the electrically conductive connection.

Unless specified otherwise, any one of an electric connection, electrical connection, conductive connection, conducting connection may be identical to a connection as defined above.

Unless specified otherwise, if two entities, including in particular nodes, points, terminals, elements, devices, etc. or combinations thereof, are said to be connected, electrically connected or to be (electrically) connected together, a connection as defined above may exist between the two entities.

All documents mentioned and/or referred to in this patent application, in particular all patent documents and any Wikipedia articles, are included by reference in their entirety.

## Claims

1. A magnetic field sensor array, in particular for measuring a magnetic field distribution, said magnetic field sensor array comprising:
a) a semiconductor substrate;
b) a plurality of magnetic field sensors, in particular Hall sensors, provided on and/or within a surface layer of the semiconductor substrate; **characterized by**
c) an at least partially transparent protection layer, in particular a glass layer or plastic layer, covering the plurality of magnetic field sensors.

2. The magnetic field sensor array of claim 1, wherein the at least partially transparent protection layer is at least partially transparent to at least a subrange of wavelengths from a UV-A, visible and/or near-infrared spectral range, wherein, in particular,
a) for at least one wavelength or range of wavelengths from a UV-A, visible and/or near-infrared spectral range, the at least partially transparent protection layer has a transmittance or a transmission coefficient of at least 0.2, preferably of at least 0.5, most preferably of at least 0.8, or
b) a maximum transmittance or a maximum transmission coefficient of the at least partially transparent protection layer within the UV-A, visible and/or near-infrared spectral range is 0.8, preferably 0.5, and most preferably 0.2.

3. The magnetic field sensor array of any preceding claim, wherein the at least partially transparent protection layer is attached, in particular permanently and/or irreversibly attached, to the semiconductor substrate, in particular to the surface layer of the semiconductor substrate, in particular by gluing, pasting or casting, in particular with the at least partially transparent protection layer being a cast layer, e.g. formed from and/or by an epoxy resin.

4. The magnetic field sensor array of any preceding claim, wherein at least a subset of the magnetic field sensors comprises a unique, visible identifier, in particular a combination of digits, numbers and/or letters, wherein each identifier is preferably different from any other identifier from the subset of magnetic field sensors.

5. The magnetic field sensor array of any preceding claim, wherein the magnetic field sensors are arranged in an array having *N* lines or rows, and *M* columns of sensors.

6. The magnetic field sensor array of any preceding claim, further comprising a plurality of light sensitive elements arranged on and/or within a surface layer of the semiconductor substrate, said light sensitive elements comprising, in particular photodiodes, e.g. CMOS cells, or a pixel of a charge-coupled device, CCD, image sensor.

7. The magnetic field sensor array of any preceding claim, wherein the magnetic field sensors are arranged in an array having *N* lines or rows, and *M* columns of sensors, in particular with a number *N*ₗ of light sensitive elements being equal to or larger than a number *N*ₘ of magnetic field sensors, in particular with *N*ₘ = *N* · *M.*

8. The magnetic field sensor array of any preceding claim, wherein in each line and/or each column,
a) at least one light sensitive element is interposed between any two adjacent magnetic field sensors; and/or
b) exactly one magnetic field sensor is interposed between any two adjacent light sensitive elements; in particular with
c) the light sensitive elements and the magnetic field sensors being alternatingly arranged in a checkerboard fashion.

9. The magnetic field sensor array of any preceding claim, wherein each of the light sensitive elements is a temperature sensor, in particular with each temperature sensor being integrated with a different one of the plurality of magnetic field sensors, preferably with a number of temperature sensors equaling a number of magnetic field sensors.

10. A method for determining a magnetic field around an object, in particular created by said object, comprising the steps of:
a) placing the object onto or near a surface of a magnetic field sensor array, in particular a magnetic field sensor array according to one of the preceding embodiments, said magnetic field sensor array comprising a plurality of magnetic field sensors;
b) obtaining an image showing at least a part of the object and at least a first subset of the magnetic field sensors, in particular by means of an optical camera;
c) determining a position and/or orientation of the object relative to the magnetic field sensor array based on the image;
d) measuring a magnetic field distribution with the magnetic field sensor array.

11. The method of claim 10, wherein to determine the position and/or orientation of the object, the image is analyzed to identify a second subset of magnetic field sensors which are obstructed from the optical camera's view by the object.

12. The method of any of claims 10 or 11, wherein
a) the object is placed between the magnetic field sensor array and the optical camera; and/or
b) the magnetic field sensor array and the optical camera are positioned on opposite sides with respect to the object.

13. The method of any of claims 10 to 12, further comprising correlating the position and/or orientation of the object relative to the magnetic field sensor, in particular the magnetic field sensor array, with magnetic field distribution as measured with the magnetic field sensor, in particular the magnetic field sensor array.

14. The method of any of claims 10 to 13, further comprising providing a dataset representative of the magnetic field distribution relative to object, in particular
a) to one or more surfaces, edges, corners, and/or a center of gravity of the object, and/or
b) to one or more markers, in particular fiducials, provided on the object.

15. The method of any of claims 10 to 14, wherein a known geometry of the object is taken into account in determining the position and/or orientation of the object relative to the magnetic field sensor, in particular the magnetic field sensor array.
